Europäisches Patentamt

European Patent Office

Office européen des brevets

(19)

(11) Publication number: **0 164 517**
**B1**

(12) **EUROPEAN PATENT SPECIFICATION**

(45) Date of publication of patent specification: **29.11.89**

(51) Int. Cl.[4]: **H 01 L 29/60, H 01 L 29/72**

(21) Application number: **85104227.5**

(22) Date of filing: **11.04.85**

(54) Heterojunction transistors.

(30) Priority: **11.05.84 US 609406**

(43) Date of publication of application:
**18.12.85 Bulletin 85/51**

(45) Publication of the grant of the patent:
**29.11.89 Bulletin 89/48**

(84) Designated Contracting States:
**DE FR GB**

(56) References cited:
**US-A-3 780 359**
**US-A-3 938 243**

**ELECTRONICS LETTERS, vol. 16, no. 1, January 1980, Hitchin, GB; D. ANKRI et al. "Design and evaluation of a planar GaAlAs-GaAs bipolar transistor", pages 41-42**

**R.E. Williams: "Gallium Arsenide Processing Techniques", Artech House, Dedham, MA, 1984, pages 228-235, 271.**

**Journal of Vacuum Science & Technology, vol. 17, no. 4, July/August 1980, pages 775-792.**

(73) Proprietor: **International Business Machines Corporation**
**Old Orchard Road**
**Armonk, N.Y. 10504 (US)**

(72) Inventor: **Tiwari, Sandip**
**791 Pinesbridge Road**
**Ossining New York 10562 (US)**

(74) Representative: **Hobbs, Francis John**
**IBM United Kingdom Limited Intellectual Property Department Hursley Park**
**Winchester Hampshire SO21 2JN (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

## Description

This invention relates to heterojunction bipolar transistors.

Transistors made of more than one type of semiconductor material are known as heterojunction transistors. Such materials are usually of the intermetallic type as gallium arsenide and gallium aluminum arsenide. These materials have some advantageous properties and some properties that require special consideration to use. In bipolar transistor structures, the size of the extrinsic base region may cause the base resistance to be higher than desirable and efforts to compensate usually involve positioning the base contact very close to either the collector electrode or the emitter electrode. Heterojunction transistors are also susceptible to saturation and steps must be taken to either pervent or control it.

Efforts to position base and collector electrodes is close proximity have been made using indirect processing such as by deposition and etching from an angle so that the dimension on the horizontal is smaller. US—A—3,938,243 discloses a technique of saturation control in silicon devices by means of a metal electrode that bridges two regions but provides an ohmic and a Schottky contact, respectively, to the two regions. Said electrode consists of platinel silicide by reacting platinel with the silicon surface in an alloying step.

According to one aspect, the invention consists in a method of providing a heterojunction bipolar transistor with an ohmic base contact and a Schottky barrier clamp for saturation control, the transistor having a p-type base region consisting of one of GaAs and GaAlAs and its collector region consisting of the other one of GaAs and GaAlAs, the method comprising placing Pd, Pt or Ni or their silicides over the intersection of the collector and base regions and sintering to form an electrode making an ohmic contact with the base region and a Schottky contact with the collector region.

According to another aspect, the invention consists in a method of providing a heterojunction bipolar transistor with an ohmic base contact and a Schottky barrier clamp for saturation control, the transistor having a p-type base region consisting of one of GaAs and GaAlAs and its emitter region consisting of the other one of GaAs and GaAlAs, the method comprising placing Pd, Pt or Ni or their silicides over the intersection of the emitter and base regions and sintering to form an electrode making an ohmic contact with the base region and a Schottky contact with the emitter region.

How the invention can be carried out will now be described by way of example, with reference to the accompanying drawings, in which:—

Fig. 1 represents a known heterojunction transistor and indicates a critical base electrode to collector spacing;

Fig. 2 represents one heterojunction transistor provided by the invention; and

Fig. 3 represents another heterojunction transistor provided by the invention.

The invention as defined in the claims involves the use of a specific type of electrode over the interface of the collector or emitter and the base region of a heterojunction transistor which when in place operates to serve the combined functions of a base electrode closely spaced to a junction and a Schottky barrier saturation control clamp between the base and either the emitter or collector of the transistor.

In order to indicate the advantages of the invention more clearly, a description will first be provided of the base to collector spacing problem.

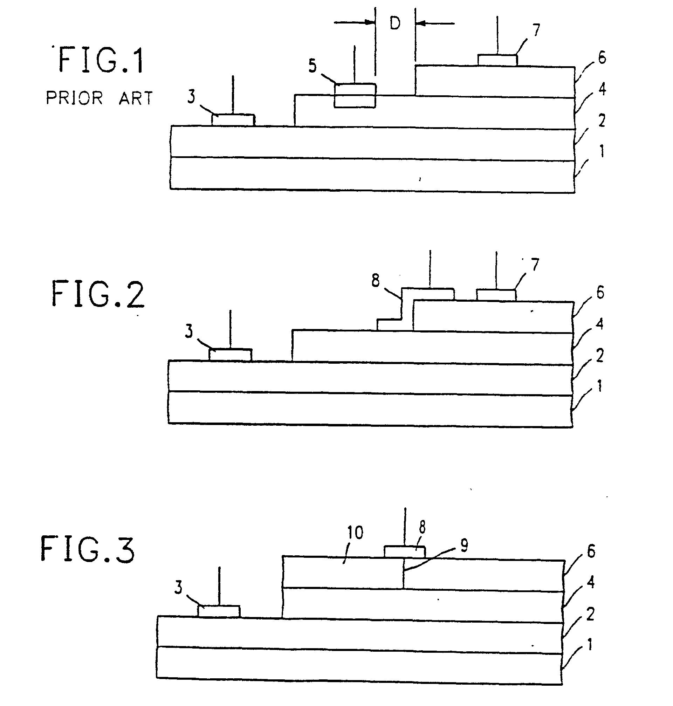

Fig. 1 represents a known type of heterojunction transistor which typically has a substrate 1 of gallium arsenide. In epitaxial relationship therewith is an n emitter region 2 of for example GaAlAs. An ohmic emitter electrode 3 is provided to the emitter region 2. In epitaxial relationship with the emitter region 2 is a base region 4 of for example p-type GaAs or p-type graded GaAlAs. An ohmic base electrode contact 5 is provided to the base region 4. In epitaxial relationship with base region 4 is a collector region 6 of n-type semiconductor material which is different from that of the base region 4 so that a heterojunction is formed. The collector region may be of GaAlAs or GaAs. An ohmic collector electrode contact 7 is provided to the region 6.

It will be apparent to one skilled in the art that the vertical distances and some horizontal distances are somewhat exaggerated for the purpose of clarity.

In the structure of Fig. 1, a high extrinsic base to collector resistance is encountered. The resistance can be reduced by reducing the distance shown in Fig. 1 as D. The smaller the distance D, the less resistance would be encountered. There is, however, a practical limit in most fabricating processes, such as in the photolithography, in that a distance much smaller than 1 μm is not achievable with present technology. The situation is aggravated when in higher response devices, the region 4 is made very thin, which in turn reduces the cross section, and the resistance increases further. In structures such as this, the resistance can be partly reduced by heavily doping the p-type region 4 to produce a lower resistivity, but when this is done undesirable capacitance results and the performance of the device deteriorates.

Referring next to Fig. 2, in accordance with the invention, an electrode 8 of a selected metal is placed over the interface of the base region and the collector region. The metal electrode 8 forms an ohmic contact with the base region and forms a Schottky barrier contact with the collector region. The metal electrode 8 further serves as the combination of a closely spaced base contact coupled with a built-in collector-to-base Schottky barrier clamp.

In Fig. 2, using the same reference numerals as Fig. 1 for like items, an $n^+$ substrate 1 is epitaxially joined to an n emitter 2 provided wtih an ohmic emitter contact 3. An epitaxial region 4 and a collector 6 forming a heterocollector junction are provided. An ohmic collector contact 7 is also provided. Several transistors may operate with a common emitter and hence may not have the contact 3.

The point of departure for the invention is the contact 8, positioned across the interface between the base 4 and the collector 6, which forms both an ohmic contact with the base region 4 and a Schottky barrier contact with the collector region 6. Since the ohmic contact with the base region 4 is at the interface between the collector region 6 and the base region 4 it is at the minimum spacing and because of the Schottky barrier impedance with the collector 6, no processing accommodation need be made to prevent shorting.

Positioning the electrode on the interface between the base and the collector results in the minimum base to collector spacing yet electrical shorting does not take place due to the metal electrode to collector Schottky barrier impedance. In operation, the electrode also serves as a clamp for the transistor. As the saturation condition is approached, the base region of these devices would reach a potential with respect to either the emitter or collector that is opposite to the normal potential but such situation is prevented because the Schottky barrier portion of the electrode of the invention at that point becomes forward biased.

Referring to Fig. 3, an alternative embodiment provided by the invention is illustrated where a portion of the collector region 6 is converted, for example by ion implantation, to the same conductivity type as the base 4 and the electrode 8 positioned across the interface 9 forms an ohmic contact with the converted region 10 and a Schottky barrier rectifying contact with the region 6. While the conversion is shown for illustration as ending at an interface between layers, in practice it may penetrate as far as desired. All other reference numerals indicate items corresponding to those in the structures of the other figures.

The preferred method of carrying out the invention involves providing for the region 1 an $n^+$ GaAs substrate doped to approximately $10^{18}$ atoms per $cm^3$. The n-type GaAlAs emitter would be doped with silicon to about $10^{17}$ atoms per $cm^3$. The p-type base 4 would be doped with beryllium or magnesium to about $10^{18}$ atoms per $cm^3$, providing a $10^{-2}$ ohm-cm base resistance. The n-type collector 6 of GaAs would be doped to about $10^{17}$ atoms per $cm^3$ with silicon.

The base collector contact 8 would be made of palladium, platinum or nickel and their silicides sintered at an approximate temperature of about 500°C. The electrodes 3 and 7 would be conventional ohmic connections such as AuGe.

It will be apparent to one skilled in the art that the electrode 8 provides a simple solution to two well known problems.

It should be noted that the metal electrode may alternatively be arranged to serve as a saturation clamp on the emitter, although the more prevalent use is as described above for a collector saturation clamp.

What has been described is an electrode that serves as a combined base to collector or base to emitter contact forming an ohmic contact to the base at the interface where the collector or emitter region joins the base and extends over the collector or emitter region forming a Schottky barrier contact thereto so that both a minimum spaced ohmic base to collector or emitter to base, contact is provided, together with a Schottky collector or emitter clamp for a heterojunction transistor.

## Claims

1. A method of providing a heterojunction bipolar transistor with an ohmic base contact and a Schottky barrier clamp for saturation control, the transistor having a p-type base region consisting of one of GaAs and GaAlAs and its collector region consisting of the other one of GaAs and GaAlAs, the method comprising placing Pd, Pt or Ni or their silicides over the intersection of the collector and base regions and sintering to form an electrode making an ohmic contact with the base region and a Schottky contact with the collector region.

2. A method of providing a heterojunction bipolar transistor with an ohmic base contact and a Schottky barrier clamp for saturation control, the transistor having a p-type base region consisting of one of GaAs and GaAlAs and its emitter region consisting of the other one of GaAs and GaAlAs, the method comprising placing Pd, Pt or Ni or their silicides over the intersection of the emitter and base regions and sintering to form an electrode making an ohmic contact with the base region and a Schottky contact with the emitter region.

## Patentansprüche

1. Methode zur Erstellung eines bipolaren Transistors mit heterogener Übergangszone mit einer leitenden Basis Verbindung und einer Schottky-Barrieren-Anschlussklemme zur Sättigungskontrolle, bei der der Transistor eine P-Typ-Basiszone aufweist, die aus dem einen GaAs and GaAlAs besteht, und die Kollektorzone aus dem anderen GaAs und GaAlAs besteht, wobei die Methode dadurch gekennzeichnet ist, daß Pd, Pt oder Ni oder deren Silizide über dem Schnittpunkt der Kollektorzone mit der Basiszone angeordnet und gesintert werden, um eine Elektrode mit einer leitenden Verbindung zur Basiszone und einer Schottky-Verbindung zur Kollektorzone zu bilden.

2. Methode zur Erstellung eines bipolaren Transistors mit heterogener Übergangszone mit einer leitenden Basis-Verbindung und einer Schottky-Barrieren-Anschlussklemme zur Sättigungskontrolle, bei der der Transistor eine P-Typ-Basiszone aufweist, die aus dem einen GaAs und GaAlAs besteht, und die Emitterzone aus dem anderen GaAs und GaAlAs besteht, wobei die Methode dadurch gekennzeichnet ist, daß Pd, Pt oder Ni oder deren Silizide über dem Schnittpunkt der Emitterzone mit der Basiszone angeordnet und gesintert werden, um eine Elektrode mit einer leitenden Verbindung zur Basiszone und einer Schottky-Verbindung zur Emitterzone zu bilden.

**Revendications**

1. Procédé de fabrication d'un transistor bipolaire à hétérojonction comportant un contact de base ohmique et un blocage à barrière Schottky pour réglage de saturation, le transistor comprenant une région de base de type p constituée d'un de GaAs et GaAlAs et une région de collecteur constituée de l'autre de GaAs et GaAlAs, le procédé consistant à placer Pd, Pt ou Ni ou leurs siliciures sur l'intersection des régions de collecteur et de base et à effectuer un frittage pour former une électrode constituant un contact ohmique avec la région de base et un contact Schottky avec la région de collecteur.

2. Procédé de fabrication d'un transistor bipolaire à hétérojonction comportant un contact de base ohmique et un blocage à barrière Schottky pour réglage de saturation, le transistor comprenant une région de base de type p composée d'un de GaAs et GaAlAs et une région d'émetteur composée de l'autre de GaAs et GaAlAs, le procédé comprenant la mise en place de Pd, Pt ou Ni ou leurs siliciures sur l'intersection des régions d'émetteur et de base et un frittage pour former une électrode constituant un contact ohmique avec la région de base et un contact Schottky avec la région d'émetteur.

FIG.1

PRIOR ART

FIG.2

FIG.3